# FASCICULE DE BREVET EUROPEEN

(11) **EP 3 353 816 B1**
(45) Date de publication et mention de la délivrance du brevet: **07.10.2020**
(21) Numéro de dépôt: 16797466.6
(22) Date de dépôt: 27.10.2016
(51) Int. Cl.: H01L 31/05

(54) **PROCEDE DE FABRICATION D'UN MODULE PHOTOVOLTAIQUE**
VERFAHREN ZUR HERSTELLUNG EINES FOTOVOLTAIKMODULS
METHOD FOR PRODUCING A PHOTOVOLTAIC MODULE

(30) Priorité: 29.10.2015 FR 1560343
(43) Date de publication de la demande: 01.08.2018
(73) Titulaire: Commissariat à l'Énergie Atomique et aux Énergies Alternatives, 75015 Paris (FR)
(72) Inventeur: BETTINELLI, Armand, 38500 Coublevie (FR); GAUME, Julien, 38110 La Tour Du Pin (FR); NOVEL, Benjamin, 73100 Saint-Offenge-Dessous (FR)
(74) Mandataire: Cabinet Camus Lebkiri
(86) Numéro de dépôt international: PCT/EP2016/075943
(87) Numéro de publication internationale: WO 2017/072238

(56) Documents cités:
- EP-A1- 1 796 177
- WO-A1-2013/106896
- DE-A1- 3 619 521
- US-A1- 2012 048 332

## Description

### DOMAINE TECHNIQUE DE L'INVENTION

La présente invention concerne un procédé de fabrication d'un module photovoltaïque.

### ARRIERE-PLAN TECHNOLOGIQUE DE L'INVENTION

Un module photovoltaïque est un assemblage de cellules photovoltaïques identiques connectées en série et/ou en parallèle afin d'obtenir en sortie du module photovoltaïque un couple courant-tension désiré. Au sein du module photovoltaïque, les cellules photovoltaïques sont agencées sous forme de « chaînes », également appelées « strings » en anglais.

A titre d'exemple, le format de module photovoltaïque le plus répandu actuellement comprend 60 cellules photovoltaïques de forme carrée, ou « pseudo-carrée », avec des côtés mesurant 156 mm. Ces 60 cellules photovoltaïques sont réparties en six chaînes de dix cellules photovoltaïques connectées en série, les six chaînes de cellules photovoltaïques étant également connectées en série.

Ce module photovoltaïque fournit alors un courant de circuit fermé égal au courant de la cellule photovoltaïque la moins performante et une tension de circuit ouvert égale à la somme des tensions de seuil des 60 cellules photovoltaïques.

La fabrication du module photovoltaïque comporte trois étapes principales dont la première est une étape de constitution des chaînes de cellules photovoltaïques interconnectées. Au cours de la deuxième étape, on réalise un empilement comportant une première plaque, ou feuille, de protection, une première couche d'encapsulant, les chaînes préalablement constituées disposées les unes à côté des autres, une deuxième couche d'encapsulant et une deuxième plaque, ou feuille, de protection. Enfin, la troisième étape est une étape dite de « lamination » au cours de laquelle l'empilement est d'abord simultanément chauffé de manière à faire fondre ou ramollir les couches d'encapsulant et mis en dépression (par pompage) pour chasser l'air de l'empilement, puis pressé toujours à chaud pour assembler toutes les couches entre elles. Un tel procédé de fabrication est décrit dans le document WO 2013/106896 A1.

Les porteurs de charge photogénérés, qui contribuent au courant électrique des cellules photovoltaïques, sont collectés grâce à un réseau d'électrodes déposées sur les faces des cellules photovoltaïques. Ces électrodes, également appelées doigts de collecte, sont étroites (<100 µm) et sont généralement formées par sérigraphie d'une pâte contenant de l'argent. Au sein d'une chaîne, le courant électrique circule d'une cellule photovoltaïque à une autre par des interconnexions reliant les doigts de collecte des cellules photovoltaïques.

Il existe actuellement deux principaux types d'interconnections des cellules photovoltaïques d'une chaîne : les interconnections sous la forme de rubans et les interconnections sous la forme de fils. Les cellules photovoltaïques interconnectées par des rubans comportent des pistes conductrices électriquement, également appelées « bus », formées en même temps que les doigts de collecte par sérigraphie. Les bus relient électriquement les doigts de collecte et sont orientés perpendiculairement aux doigts de collecte. Les rubans sont soudés sur les bus pendant l'étape de constitution des chaînes. Les rubans ont généralement une section rectangulaire et sont par exemple constitués de cuivre enrobé d'un alliage fusible, typiquement un alliage d'étain et de plomb ou un alliage d'étain et d'argent.

Selon la technique d'interconnexion utilisée, les cellules photovoltaïques interconnectées par des fils peuvent ou non comporter des bus. En effet, pareillement aux rubans, les fils peuvent être soudés sur les bus des cellules photovoltaïques. Cependant, cette technique d'interconnexion est difficile à mettre en œuvre et implique une faible cadence de production des modules photovoltaïques.

Une autre technique d'interconnexion, décrite dans l'article [« Smart Wire Connection Technology », T. Sôderstrôm et al., Proceedings of the 28th European Photovoltaics Solar Energy Conference, pp.495-499, 2013], consiste à utiliser un film support, par exemple en polytéréphtalate d'éthylène (PET) et en polyéthylène à basse densité (PEBD), sur lequel sont disposés les fils. Le film support est chauffé, à une température avoisinant 100°C, de manière à permettre dans un premier temps le collage des fils sur le film, puis dans un second temps le collage du film (et donc des fils) sur les cellules photovoltaïques lors de la constitution des chaînes.

Dans le cas de cette dernière technique, il n'est pas nécessaire que les cellules photovoltaïques comportent des bus. En effet, contrairement au cas des interconnections soudées sur les bus des cellules photovoltaïques, les liaisons électriques entre les doigts de collecte et les interconnexions ne sont pas établies au cours de l'étape de constitution des chaînes mais au cours de l'étape de lamination. Pour ce faire, les fils comportent un revêtement formé d'un alliage présentant un point de fusion inférieur à la température de lamination. Le revêtement est par exemple un alliage d'étain et d'indium ayant un point de fusion d'environ 120°C.

Quelle que soit le type d'interconnexions utilisé, l'étape de constitution des chaînes de cellules photovoltaïques implique un temps de production élevé. De plus, les équipements nécessaires pour effectuer cette étape sont coûteux et ont un encombrement important au sein de la ligne de production.

Par ailleurs, une fois les chaînes constituées, il est nécessaire de les manipuler pour les placer dans l'empilement. Ces manipulations sont susceptibles d'endommager les chaînes de cellules photovoltaïques, notamment au niveau des interconnexions, portant ainsi atteinte à la fiabilité du module photovoltaïque.

### RESUME DE L'INVENTION

La présente invention vise à réduire le coût de production d'un module photovoltaïque en diminuant le temps et le nombre d'équipements nécessaires à la fabrication du module photovoltaïque. Parallèlement à la réduction du coût de production, la présente invention vise également à améliorer la fiabilité du module photovoltaïque.

L'invention concerne donc un procédé de fabrication d'un module photovoltaïque selon la revendication 1, comportant des cellules photovoltaïques, le procédé comportant les étapes suivantes :
- fournir une première plaque de protection ;
- déposer sur la première plaque de protection une couche d'un matériau encapsulant, le matériau encapsulant étant un adhésif sensible à la pression ;
- poser alternativement sur la couche de matériau encapsulant les cellules photovoltaïques et des éléments d'interconnexion aptes à relier électriquement les cellules photovoltaïques, les éléments d'interconnexion étant répartis en des premiers groupes d'éléments d'interconnexion et des deuxièmes groupes d'éléments d'interconnexion, chaque cellule photovoltaïque étant posée en contact avec le matériau encapsulant sur un premier groupe d'éléments d'interconnexion et chaque cellule photovoltaïque étant recouverte par un deuxième groupe d'éléments d'interconnexion.

Grâce au fait que le matériau encapsulant déposé sur la première plaque de protection est un adhésif sensible à la pression, les cellules photovoltaïques peuvent être posées et interconnectées directement sur la première plaque de protection du module photovoltaïque. Il n'y a alors pas d'étape préalable de constitution de chaînes de cellules photovoltaïques, et donc pas de manipulation de ces chaînes. La fiabilité et la cadence de production des modules photovoltaïques sont ainsi augmentées.

De préférence, les cellules photovoltaïques et les éléments d'interconnexion sont posés de manière à former au moins une chaîne de cellules photovoltaïques adjacentes connectées en série, selon la séquence suivante :
- (a) poser le premier groupe d'éléments d'interconnexion sur la couche de matériau encapsulant ;
- (b) poser une cellule photovoltaïque sur le premier groupe d'éléments d'interconnexion ;
- (c) poser une première partie du deuxième groupe d'éléments d'interconnexion sur ladite cellule photovoltaïque et une deuxième partie du deuxième groupe d'éléments d'interconnexion sur une zone de la couche de matériau encapsulant adjacente à ladite cellule photovoltaïque ;
les étapes (b) et (c) étant répétées pour chaque cellule photovoltaïque adjacente de ladite au moins une chaîne, la deuxième partie du deuxième groupe d'éléments d'interconnexion de ladite cellule photovoltaïque correspondant au premier groupe d'éléments d'interconnexion de la cellule photovoltaïque adjacente.

Avantageusement, la deuxième partie du deuxième groupe d'éléments d'interconnexion est posée avant la première partie du deuxième groupe d'éléments d'interconnexion.

Le procédé selon l'invention peut en outre comporter les étapes suivantes :
- déposer une couche d'un matériau encapsulant additionnel sur les cellules photovoltaïques et les éléments d'interconnexion ;
- placer une deuxième plaque de protection sur la couche de matériau encapsulant additionnel.

Dans un premier mode de mise en œuvre du procédé selon l'invention, les cellules photovoltaïques présentent deux faces opposées, les cellules photovoltaïques comportant sur chacune de leurs faces des doigts de collecte s'étendant selon une première direction, les éléments d'interconnexion étant des fils d'interconnexion orientés selon une deuxième direction orthogonale à la première direction.

Dans ce premier mode de mise en œuvre, le procédé comporte une étape de dépôt sur chaque cellule photovoltaïque d'une bande d'adhésif sensible à la pression maintenant en position le deuxième groupe d'éléments d'interconnexion sur ladite cellule photovoltaïque. Avantageusement, la bande d'adhésif sensible à la pression maintient également en position la cellule photovoltaïque sur la couche de matériau encapsulant.

Le procédé selon le premier mode de mise en œuvre comporte également une étape de lamination du module photovoltaïque effectuée à une température permettant le ramollissement du matériau encapsulant. Avantageusement, les fils d'interconnexion comportent un revêtement formé d'un alliage présentant un point de fusion inférieur à la température ramollissement du matériau encapsulant.

De préférence, les fils d'interconnexion présentent un diamètre inférieur ou égal à 200µm. Ainsi, il est plus facile d'établir un contact entre la cellule photovoltaïque et la couche de matériau encapsulant adhésif lors de l'étape de pose de la cellule photovoltaïque.

Dans un deuxième mode de mise en œuvre du procédé selon l'invention, les cellules photovoltaïques présentent deux faces opposées, les cellules photovoltaïques comportant sur chacune de leurs faces des doigts de collecte s'étendant selon une première direction et des bus s'étendant selon une deuxième direction orthogonale à la première direction, les éléments d'interconnexion étant des rubans d'interconnexion alignés avec les bus des cellules photovoltaïques.

Avant la pose de chaque cellule photovoltaïque, on procède avantageusement à une étape de dépôt d'une colle conductrice électriquement sur les bus des deux faces de ladite cellule photovoltaïque, la colle conductrice électriquement maintenant en position ladite cellule photovoltaïque sur le premier groupe d'éléments d'interconnexion, et le deuxième groupe d'éléments d'interconnexion sur ladite cellule photovoltaïque.

De préférence, les bus des cellules photovoltaïques comprennent une succession de plages métallisées espacées les unes des autres, la colle conductrice électriquement étant déposée sous forme de lignes reliant les plages métallisées ou sous forme de points de colle sur les plages métallisées. Avantageusement, chaque point de colle est déposé de manière à couvrir une surface supérieure à celle de la plage métallisée.

Le procédé selon le deuxième mode de mise en œuvre comporte une étape de lamination du module photovoltaïque effectuée à une température permettant le ramollissement du matériau encapsulant. Avantageusement, la colle conductrice électriquement présente une température de début de durcissement inférieure à la température de ramollissement du matériau encapsulant.

Dans une variante des premier et deuxième modes de mise en œuvre du procédé selon l'invention, les cellules photovoltaïques présentent deux faces opposées, les cellules photovoltaïques comportant sur chacune de leurs faces des doigts de collecte s'étendant selon une première direction, le procédé comportant les étapes suivantes :
- découper les cellules photovoltaïques suivant une deuxième direction orthogonale à la première direction pour former une pluralité de sous-cellules ;
- aligner des sous-cellules dans la première direction de façon à constituer des groupes de sous-cellules, chaque groupe de sous-cellules étant considéré et manipulé comme une seule cellule photovoltaïque.

L'invention et ses différentes applications seront mieux comprises à la lecture de la description qui suit et à l'examen des figures qui l'accompagnent.

### BREVE DESCRIPTION DES FIGURES

L'invention et ses différentes applications seront mieux comprises à la lecture de la description qui suit et à l'examen des figures qui l'accompagnent, parmi lesquelles :
- les figures 1A à 1G représentent schématiquement et en vue de coupe un premier module photovoltaïque à différentes étapes de fabrication, d'après un premier mode de mise en œuvre du procédé selon l'invention ;
- les figures 2A, 2B et 2E représentent schématiquement et en vue de dessus le premier module photovoltaïque, respectivement lors des étapes des figures 1A, 1B et 1E;
- la figure 3 représente schématiquement et en vue de dessus une variante du premier module photovoltaïque comportant des cellules photovoltaïques de plus petite taille ;
- la figure 4 représente schématiquement une vue en coupe d'un deuxième module photovoltaïque fabriqué selon un deuxième mode de mise en œuvre du procédé selon l'invention ;
- la figure 5 représente schématiquement une vue de dessus d'une cellule photovoltaïque du deuxième module photovoltaïque.

Les figures ne sont présentées qu'à titre indicatif et nullement limitatif de l'invention.

Pour plus de clarté, les éléments identiques ou similaires sont repérés par des signes de référence identiques sur toutes les figures.

### DESCRIPTION DETAILLEE DE MODES DE REALISATION DE L'INVENTION

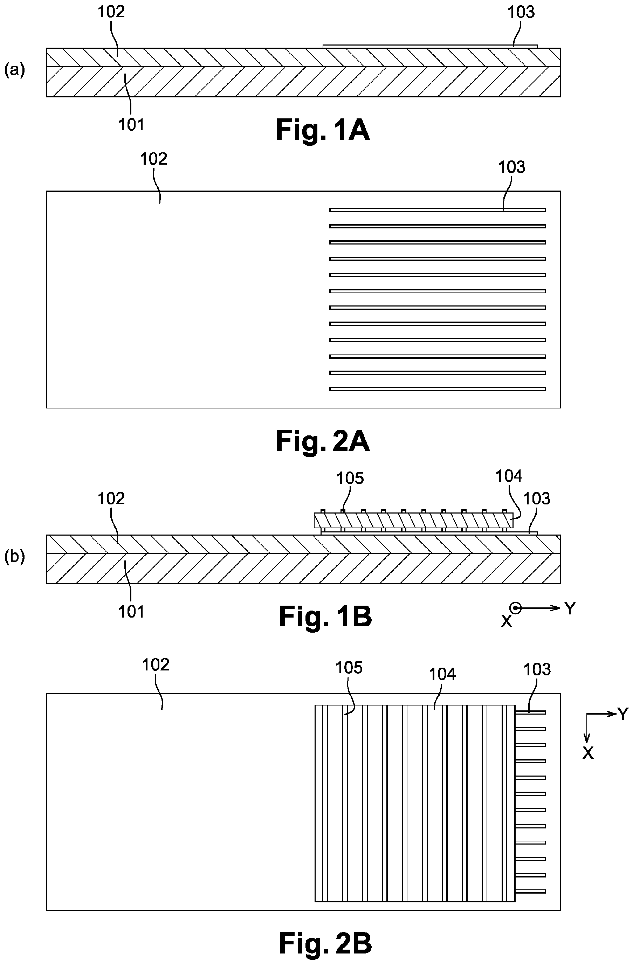

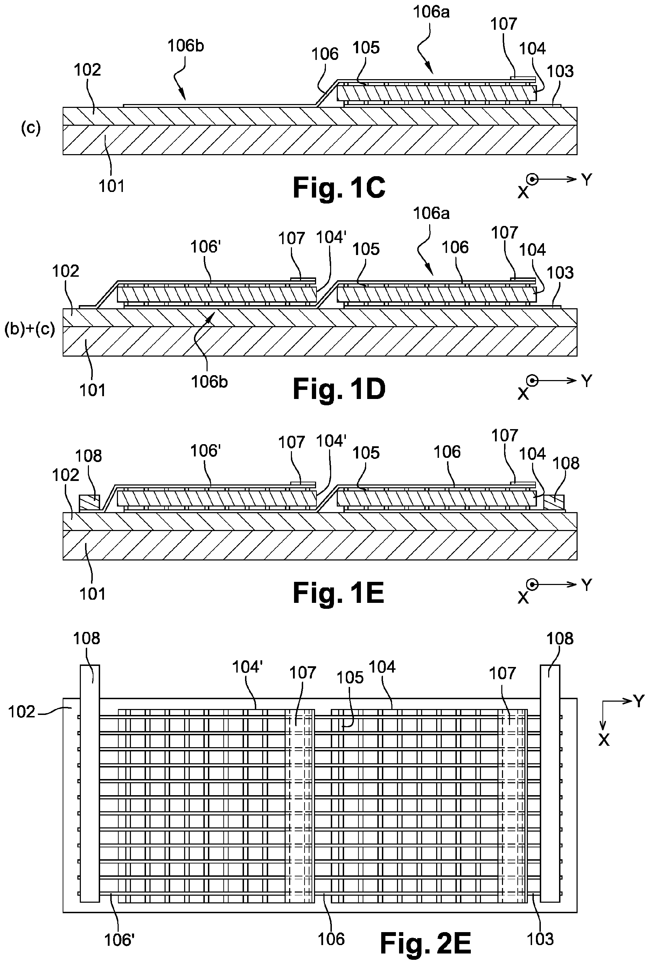

Un premier mode de mise en œuvre du procédé de fabrication d'un module photovoltaïque selon l'invention va maintenant être décrit, en référence aux figures 1A à 1G, 2A, 2B et 2E. Les figures 1A à 1G représentent en vue de coupe le module photovoltaïque au cours des différentes étapes du procédé, tandis que les figures 2A, 2B et 2E sont des vues de dessus du module correspondant aux étapes des figures 1A, 1B et 1E respectivement.

La figure 1A montre une première plaque de protection 101 du module photovoltaïque, fournie au cours d'une étape initiale. La plaque de protection 101 est de préférence un support rigide sur lequel est assemblé le module photovoltaïque. La plaque de protection 101 est par exemple une plaque de verre ou une plaque d'un matériau polymère.

De préférence, la plaque de protection 101 correspond à la face avant du module photovoltaïque, c'est-à-dire la face exposée à un rayonnement incident lorsque le module photovoltaïque est en fonctionnement. En effet, la plaque de protection de la face avant, transparente au rayonnement incident, est généralement rigide alors que la face arrière du module photovoltaïque peut être un fond blanc souple, sur lequel il est plus difficile d'assembler le module photovoltaïque.

Une première couche 102 d'un matériau encapsulant est ensuite déposée sur la plaque de protection 101. Le matériau encapsulant de cette première couche 102 est un adhésif sensible à la pression, également appelé PSA pour « Pressure Sensitive Adhesive » en anglais. Cela signifie que les objets posés en contact avec le matériau encapsulant adhèrent à ce dernier. Le matériau encapsulant est adhésif à température ambiante, autrement dit dans les conditions standards de fabrication du module photovoltaïque, vers 25 °C. De plus, le matériau encapsulant possède une transmittance supérieure à 85% pour des longueurs d'onde comprises entre 400 et 1100 nm, et un indice de réfraction le plus proche possible de celui de la plaque de protection 101. Ainsi, les pertes optiques par transmission sont limitées et les performances du module photovoltaïque sont optimisées.

Le matériau adhésif à pression sensible est une base d'élastomère possédant une résine pégueuse thermoplastique de faible masse moléculaire, par exemple de type ester. La base d'élastomère est par exemple un acrylique, un caoutchouc (butyle, naturel ou silicone), un nitrile, un copolymère à blocs styrène (SBC) (ex. Styrene-butadiene-styrene (SBS), Styrene-ethylene/butylene-styrene (SEBS), Styrene-ethylene/propylene (SEP), Styrene-isoprene-styrene (SIS)) ou un éther de vinyle.

La base d'élastomère peut être également de l'éthylène-acétate de vinyle, ou EVA pour « ethylene-vinyl acetate » en anglais, avec un taux élevé d'acétate de vinyle pouvant atteindre 33%.

Le procédé de fabrication comporte en outre des étapes de pose, sur la couche 102 de matériau encapsulant, d'une cellule photovoltaïque et d'éléments d'interconnexions aptes à relier électriquement les cellules photovoltaïques du module photovoltaïque. Ces étapes sont répétées plusieurs fois en fonction du nombre de cellules photovoltaïques à assembler dans le module photovoltaïque. Les cellules photovoltaïques du module sont de préférence toutes identiques.

Dans le procédé de l'invention, les cellules photovoltaïques forment toujours des chaînes mais celles-ci sont constituées lors de l'étape d'empilement des constituants du module, directement sur la face avant du module photovoltaïque. Ainsi, contrairement aux procédés de l'art antérieur, il n'est plus nécessaire de manipuler une par une les chaînes pour les disposer sur la face avant. La présente invention permet donc de se prémunir d'éventuels dommages causés par ces manipulations, et améliore ainsi la fiabilité du module photovoltaïque. De plus, l'équipement réalisant la constitution des chaînes est supprimé, ce qui représente une économie importante et un gain de place dans la ligne de production des modules photovoltaïques.

Les cellules photovoltaïques et les éléments d'interconnexions du module photovoltaïque sont posés alternativement selon une séquence déterminée par la manière d'interconnecter les cellules photovoltaïques des chaînes du module photovoltaïque, c'est-à-dire en série ou en parallèle.

Dans le mode de mise en œuvre des figures 1A-1G, les cellules photovoltaïques au sein de chaque chaîne sont interconnectées en série. La séquence correspondante est, dans un souci de simplification, décrite pour une chaîne de deux cellules seulement. Bien sûr, un module photovoltaïque comprend généralement plusieurs chaînes, chaque chaîne comprenant un nombre plus important de cellules.

La séquence débute par la pose, au cours d'une étape (a), d'un premier groupe d'éléments d'interconnexion 103 sur la couche 102 de matériau encapsulant, comme illustré sur la figure 1A. Le premier groupe d'éléments d'interconnexion 103 est posé en contact avec le matériau encapsulant et adhère donc à ce dernier. De ce fait, le premier groupe d'éléments d'interconnexion 103 est immobilisé lors de l'assemblage du module photovoltaïque.

Comme illustré en vue de dessus sur la figure 2A, les éléments d'interconnexion du premier groupe 103 sont ici des fils électriques disposés parallèlement les uns aux autres, par exemple au nombre de 12.

Une cellule photovoltaïque 104 est ensuite posée, au cours d'une étape (b), sur le premier groupe d'éléments d'interconnexion 103 comme illustré sur les figures 1B et 2B. La dépose est réalisée avec une légère pression permettant de mettre en contact la cellule photovoltaïque 104 avec la couche 102 de matériau encapsulant, ce qui est rendu possible grâce à la flexibilité de la cellule photovoltaïque 104 et de la déformabilité de la couche 102 dans laquelle les fils s'enfoncent légèrement. De la même manière que pour le premier groupe d'éléments d'interconnexion 103, la cellule photovoltaïque 104 est maintenue en position grâce aux propriétés adhésives du matériau encapsulant.

La cellule photovoltaïque 104 est de forme carrée, ou « pseudo-carrée » avec des angles arrondis ou tronqués. Ses côtés mesurent par exemple 156 mm. La cellule photovoltaïque 104 présente deux faces opposées, chacune de ces faces comportant des doigts de collecte 105 s'étendant selon une première direction X parallèle à deux côtés opposés de la cellule photovoltaïque 104.

De préférence, les éléments d'interconnexion du premier groupe 103 sont orientés selon une deuxième direction Y orthogonale à la première direction X des doigts de collecte 105. Le premier groupe d'éléments d'interconnexion 103 et les doigts de collecte 105 de la cellule photovoltaïque 104 forment ainsi un maillage régulier permettant de collecter efficacement et de manière homogène les porteurs de charges photogénérés dans la cellule photovoltaïque 104.

Après la pose de la cellule photovoltaïque 104 au cours de l'étape (b), un deuxième groupe d'éléments d'interconnexion 106 est posé, au cours d'une étape (c), sur la couche 102 de matériau encapsulant et sur la cellule photovoltaïque 104, comme illustré sur la figure 1C. Le deuxième groupe d'éléments d'interconnexion 106 est de préférence orienté selon la deuxième direction Y. Le premier groupe d'éléments d'interconnexion 103 et le deuxième groupe d'éléments d'interconnexion 106 sont donc parallèles.

Dans ce premier mode de mise en œuvre, les cellules photovoltaïques de la chaîne sont interconnectées en série. Le deuxième groupe d'éléments d'interconnexion 106 comporte donc une première partie 106a posée sur la cellule photovoltaïque 104 et une deuxième partie 106b posée sur une zone de la couche 102 de matériau encapsulant adjacente à la cellule photovoltaïque 104, zone sur laquelle une nouvelle cellule photovoltaïque sera déposée ultérieurement. A cette fin, cette zone présente une surface sensiblement égale à celle d'une cellule photovoltaïque.

Avantageusement, la deuxième partie 106b du deuxième groupe d'éléments d'interconnexion 106 est posée avant la première partie 106a. Ainsi, la deuxième partie 106b adhère au matériau encapsulant ce qui facilite la pose du deuxième groupe d'éléments d'interconnexion 106 dans son intégralité.

Comme indiqué précédemment, les éléments d'interconnexion 103, 106 sont dans ce premier mode de mise en œuvre des fils, par exemple en cuivre, dont le nombre est avantageusement compris entre 10 et 40. Plus le nombre de fils posés est élevé, plus il est possible de réduire le diamètre de ces fils. Le diamètre des fils est par exemple compris entre 100 µm et 300 µm, et de préférence compris entre 100 µm et 200 µm. En effet, plus le diamètre des fils est faible, plus il est facile d'établir le contact de la cellule photovoltaïque 104 sur la couche 102 de matériau encapsulant.

L'utilisation du matériau encapsulant adhésif évite de recourir à un film support, comme dans l'art antérieur (film en PET-PEDB), pour interconnecter des cellules photovoltaïques au moyen de fils. On s'affranchit alors des problèmes liés à l'utilisation de ce film support. En effet, dans les procédés de fabrication de l'art antérieur, l'ajout d'une interface supplémentaire comme le film support en PET augmente d'une part les pertes en transmission du rayonnement incident, et d'autre part le risque de délamination du module photovoltaïque.

De plus, le choix du matériau encapsulant est plus limité dans les procédés de l'art antérieur car celui-ci doit être compatible avec le film support et contenir des agents bloqueurs de rayonnement ultraviolet afin de protéger le film support. Ce dernier est sensible au vieillissement et peut s'opacifier ou jaunir avec le temps, réduisant ainsi les performances du module photovoltaïque.

En plus de s'affranchir de ces inconvénients, il est désormais possible d'utiliser un encapsulant dont le seuil de coupure dans le rayonnement ultraviolet est décalé, ce qui permet de capter plus de photons. Un tel matériau encapsulant est appelé « low-cut off » en anglais et est obtenu en ajustant la concentration en agents bloqueurs de rayonnement ultraviolet dans l'encapsulant. Cela peut être intéressant pour certaines technologies de cellules photovoltaïques car les photons sont plus énergétiques dans le domaine des ultraviolets que dans le domaine visible.

Avantageusement, une bande d'un matériau adhésif sensible à la pression 107 est déposée sur la cellule photovoltaïque 104 afin de maintenir en position la première partie 106a du deuxième groupe d'éléments d'interconnexion 106. En effet, rien n'empêchait jusqu'alors la première partie 106a du deuxième groupe d'éléments d'interconnexion 106 posée sur la cellule photovoltaïque 104 de bouger, et de réduire l'homogénéité du maillage.

Dans ce premier mode de mise en œuvre, la bande d'adhésif 107 est déposée sur la première partie 106a du deuxième groupe d'éléments d'interconnexion 106 et en contact avec la cellule photovoltaïque 104. Pendant l'étape de pose des éléments d'interconnexion, ceux-ci sont soumis à une tension afin d'être posés de manière tendue. La bande d'adhésif 107 est de préférence déposée avant que la tension exercée sur les fils ne soit relâchée. Ainsi, la première partie 106a du deuxième groupe d'éléments d'interconnexion 106 est maintenue en position lorsque les fils sont relâchés.

Dans une variante de mise en œuvre, la bande d'adhésif 107 est déposée sur la cellule photovoltaïque 104 avant la pose du deuxième groupe d'éléments d'interconnexion 106. Ainsi, la première partie 106a du deuxième groupe d'éléments d'interconnexion 106 est posée directement sur la bande d'adhésif 107.

Cette variante est avantageusement utilisée lorsque les fils ont un gros diamètre, par exemple compris entre 200 et 300 µm, ce qui rend difficile l'établissement du contact entre la cellule photovoltaïque 104 et la couche 102 de matériau encapsulant lors de l'étape (b) de pose la cellule photovoltaïque 104. Dans ce cas, la bande d'adhésif 107 est déposée de manière à déborder de la cellule photovoltaïque 104 sur la couche 102 de matériau encapsulant. Ainsi, la bande d'adhésif 107 maintient en position à la fois la cellule photovoltaïque 104 et la première partie 106a du deuxième groupe d'éléments d'interconnexion 106.

La bande d'adhésif 107 est de préférence réalisée dans le même matériau que la couche 102 de matériau encapsulant, ce qui permet de simplifier la mise en œuvre du procédé de fabrication.

Lorsque le deuxième groupe d'éléments d'interconnexion 106 est en place, l'étape (b) de pose de la cellule photovoltaïque 104 et l'étape (c) de pose du deuxième groupe d'éléments d'interconnexion 106, décrites précédemment, sont répétées pour une nouvelle cellule photovoltaïque 104' et pour un nouveau groupe d'éléments d'interconnexion 106', comme illustré sur la figure 1D.

La nouvelle cellule photovoltaïque 104' est posée sur la zone de la couche 102 de matériau encapsulant adjacente à la cellule photovoltaïque 104. Dans cette zone se trouve la deuxième partie 106b du deuxième groupe d'éléments d'interconnexion 106, qui constitue donc la première partie des interconnexions en contact avec la cellule photovoltaïque 104' (i.e. le premier groupe d'éléments d'interconnexion 103 située sous la cellule photovoltaïque, en faisant une analogie avec la précédente étape (b) de pose de la cellule photovoltaïque 104).

Ensuite, le nouveau groupe d'éléments d'interconnexion 106' est posé sur la couche 102 de matériau encapsulant et sur la cellule photovoltaïque 104' de la même manière que le deuxième groupe d'éléments d'interconnexion 106 précédemment posé. Lorsque la chaîne compte plus de deux cellules, les étapes (b) et (c) sont répétées jusqu'à compléter la chaîne.

A chaque extrémité de la chaîne de cellules, c'est-à-dire au début et à la fin de la séquence de pose des cellules photovoltaïques et des éléments d'interconnexions, les éléments d'interconnexion (103 et 106' sur la figure 1D) s'étendent sur une longueur légèrement supérieure à celle d'une cellule photovoltaïque, alors que les éléments d'interconnexion entre deux cellules consécutives (106 sur la figure 1D) ont une longueur d'environ deux fois celle de la cellule.

Lorsque toutes les cellules photovoltaïques et tous les éléments d'interconnexion de la chaîne sont placés, des rubans d'interconnexion 108 sont posés à chaque extrémité de la chaîne sur la portion du groupe d'éléments d'interconnexion qui dépasse de chaque cellule extrême, comme illustré sur les figures 1E et 2E. Les rubans d'interconnexion 108 sont disposés de manière transversale par rapport aux éléments d'interconnexion et sont également maintenus en position grâce au caractère adhésif de la couche 102 de matériau encapsulant. Ces rubans d'interconnexion 108 forment les bornes de la chaîne de cellules et, lorsque le module photovoltaïque comporte plusieurs chaînes, permettent de connecter en série et/ou en parallèle ces différentes chaînes. Ce sont par exemple des rubans de cuivre ayant une largeur de 5 mm et revêtus d'un alliage fusible comme un alliage d'étain, de plomb et d'argent.

A ce moment, les rubans d'interconnexion 108 peuvent éventuellement être soudés aux éléments d'interconnexion, à une température d'environ 200°C qui permet la fusion du revêtement des rubans d'interconnexion 108. Cependant, dans ce premier mode de mise en œuvre, les rubans d'interconnexion 108 sont soudés aux éléments d'interconnexion de préférence pendant une étape de lamination effectuée ultérieurement, et qui sera décrite un peu plus loin. Le fait de souder les rubans d'interconnexion 108 pendant l'étape de lamination permet de gagner du temps en réduisant le nombre d'étape nécessaire à la fabrication du module photovoltaïque.

Dans le cas d'un module photovoltaïque comportant plusieurs chaînes, celles-ci sont de préférence réalisées simultanément. Ainsi, le temps de production du module photovoltaïque est réduit.

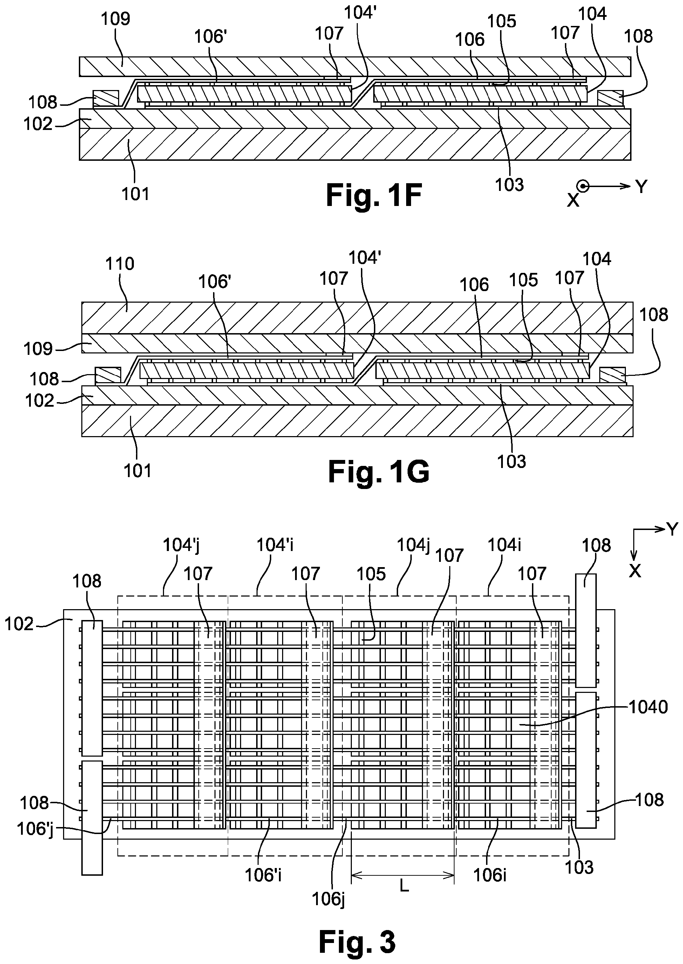

Ensuite, une deuxième couche 109 d'un matériau encapsulant est déposée sur les cellules photovoltaïques et les éléments d'interconnexion, comme illustré sur la figure 1F. Cette deuxième couche 109 de matériau encapsulant est de préférence identique à la première couche 102 de matériau encapsulant adhésif afin de simplifier la ligne de production du module photovoltaïque. Alternativement, cette deuxième couche 109 peut être formée d'un matériau encapsulant classiquement utilisé et ne possédant pas de propriétés adhésives.

A ce stade, le module photovoltaïque est un empilement comportant la première plaque de protection rigide 101, la première couche 102 de matériau encapsulant, de type adhésif sensible à la pression (PSA), les cellules photovoltaïques 104, 104' interconnectées par les éléments d'interconnexions 103, 106, 106', les rubans d'interconnexion 108 et la deuxième couche 109 de matériau encapsulant.

Une deuxième plaque de protection 110 formant la face arrière du module photovoltaïque est ensuite posée sur l'empilement, comme illustré sur la figure 1G, puis celui-ci est soumis à l'étape de lamination citée précédemment au cours de laquelle l'empilement est d'abord simultanément chauffé de manière à faire fondre ou ramollir les couches 102, 109 de matériau encapsulant et mis en dépression (par pompage) pour chasser l'air de l'empilement, puis pressé toujours à chaud pour assembler toutes les couches entre elles. L'étape de lamination se déroule par exemple à une température de 160°C.

Avantageusement, les fils d'interconnexion comportent un revêtement formé d'un alliage présentant un point de fusion inférieur à la température de ramollissement des matériaux encapsulant. Le revêtement est par exemple un alliage d'étain et d'indium ayant un point de fusion avoisinant 120°C. Ainsi, les connexions électriques entre les fils et les doigts de collectes des cellules photovoltaïques sont réalisées pendant l'étape de lamination, ce qui permet de réduire le temps de production, notamment par rapport à une technique nécessitant de souder les fils. De même, les connexions électriques entre les fils et les rubans d'interconnexion 108 sont aussi réalisées pendant cette étape de lamination.

Le premier mode de mise en œuvre du procédé de fabrication d'un module photovoltaïque selon l'invention a été décrit pour l'interconnexion de cellules photovoltaïques 104, 104' de taille usuelle. Actuellement, les cellules photovoltaïques les plus répandues sont les cellules au format 156 mm par 156 mm. Dans une variante de ce premier mode de mise en œuvre, décrite en référence à la figure 3, des cellules photovoltaïques 1040 de plus petite taille sont interconnectées. Ces cellules photovoltaïques 1040 sont par exemple obtenues en découpant des cellules photovoltaïques initiales 104, 104', utilisées dans le premier mode de mise en œuvre, en plusieurs cellules 1040 appelées « sous-cellules » 1040.

Les cellules photovoltaïques initiales 104, 104' sont découpées suivant la deuxième direction Y orthogonale aux doigts de collecte 105. Les cellules photovoltaïques initiales 104, 104' peuvent en plus être découpées suivant la première direction X dans laquelle s'étendent les doigts de collecte 105. De préférence, les cellules photovoltaïques initiales 104, 104' sont découpées de manières à obtenir des sous-cellules 1040 ayant des surfaces sensiblement identiques et ayant toutes une même dimension L dans la deuxième direction Y. Par exemple, une cellule photovoltaïque carrée de 156 par 156 mm est découpée en 6 sous-cellules de 78 mm par 52 mm, comme illustré sur la figure 3.

L'intérêt d'utiliser des sous-cellules 1040 de plus petite taille est d'augmenter, pour une même surface de module photovoltaïque, le nombre de cellules à interconnecter. Il est ainsi possible de réaliser des modules dits « haute tension » en interconnectant les sous-cellules 1040 en série. Par exemple, en interconnectant 6 fois plus de cellules, la tension du module photovoltaïque est multipliée par 6.

Le nombre de cellules à interconnecter ayant augmenté, la durée nécessaire à l'assemblage du module photovoltaïque est également augmentée. Afin d'améliorer la productivité, le procédé selon l'invention est avantageusement appliqué à des groupes 104i, 104j, 104'i, 104'j de sous-cellules 1040 plutôt qu'aux sous-cellules 1040 individuellement. Chaque groupe 104i, 104j, 104'i, 104'j de sous-cellules 1040 est considéré et manipulé comme s'il s'agissait d'une seule cellule photovoltaïque. Les groupes 104i, 104j, 104'i, 104'j sont constitués de sous-cellules 1040 disposées côte à côte dans la première direction X, et sont interconnectés par des éléments d'interconnexion 103, 106i, 106j, 106'i, 106'j, comme illustré sur la figure 3. De préférence, les groupes 104i, 104j, 104'i, 104'j présentent une dimension selon la première direction X sensiblement identique à celle des cellules photovoltaïques initiales 104, 104'. Ainsi, le nombre d'éléments d'interconnexion à poser dans la première direction X reste inchangé.

Dans cette variante du premier mode de mise en œuvre illustrée à la figure 3, les groupes 104i, 104j, 104'i, 104'j sont constitués de 3 sous-cellules 1040 et ont une taille d'environ 78 mm par 156 mm (3 x 52 mm). En termes de productivité, cela revient à connecter des demi-cellules de 78 mm par 156mm, c'est-à-dire que la capacité de production est divisée par deux par rapport à la connexion de cellules entières de 156 mm par 156mm. Cependant, 6 fois plus de sous-cellules 1040 sont interconnectées, ce qui permet de réduire le coût de production des modules photovoltaïques haute tension.

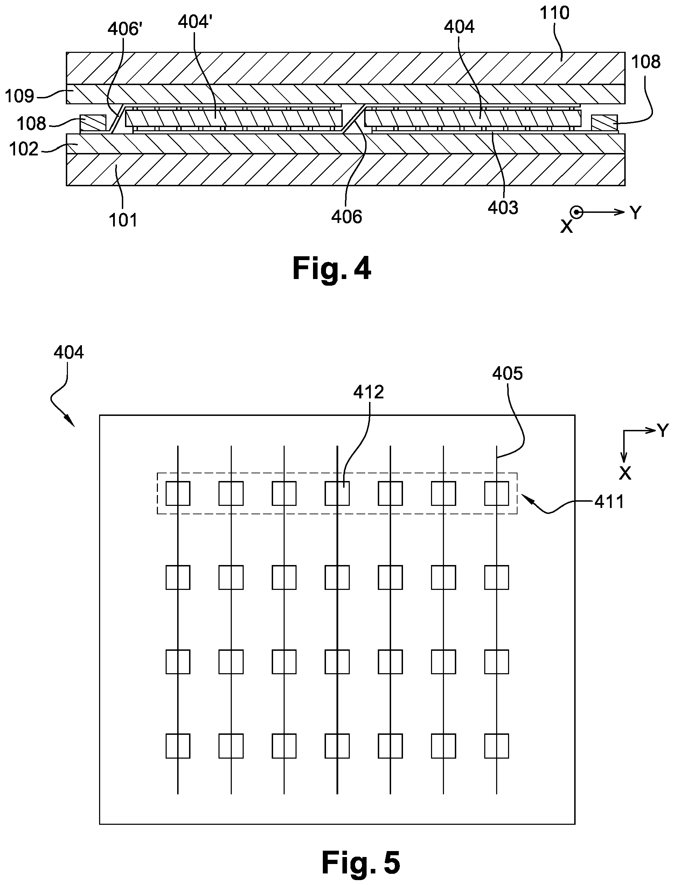

Un deuxième mode de mise en œuvre du procédé de fabrication d'un module photovoltaïque selon l'invention va maintenant être décrit en référence à la figure 4. Comme dans le premier mode de mise en œuvre du procédé, le module photovoltaïque fabriqué est un empilement comportant une première plaque de protection 101 rigide et transparente, une première couche 102 de matériau encapsulant, de type adhésif sensible à la pression (PSA), des cellules photovoltaïques identiques 404, 404' interconnectées en série par des éléments d'interconnexions 403, 406, 406', une deuxième couche 109 de matériau encapsulant et une deuxième plaque de protection 110.

Les cellules photovoltaïques 404, 404' et les éléments d'interconnexion 403, 406, 406' forment une chaîne et sont posés selon la même séquence que pour le premier mode de mise en œuvre décrit précédemment. Des rubans d'interconnexion 108 sont également posés à chaque extrémité de la chaîne.

Ce deuxième mode de mise en œuvre se différencie du premier en ce que les éléments d'interconnexion 403, 406, 406' entre les cellules photovoltaïques sont des rubans et en ce que les cellules photovoltaïques 404, 404' comportent, sur chacune de leur face, des bus sur lesquels sont connectés les rubans. Ces derniers ont par exemple une largeur comprise entre 200 et 800 µm, et une épaisseur comprise entre 10 et 40 µm.

La figure 5 est une vue de dessus de la cellule 404 montrant que les doigts de collecte 405 s'étendent selon la première direction X et que les bus 411 s'étendent selon la deuxième direction Y perpendiculaire. Les bus 411 comprennent de préférence une succession de plages métallisées 412 espacées les unes des autres. Les bus 411 sont donc discontinus, ce qui permet de réduire la quantité de métal nécessaire pour les réaliser, généralement de l'argent. Ainsi, le coût des cellules photovoltaïques 404, 404', et par conséquent celui du module photovoltaïque, est réduit. Le nombre de bus 411, et donc de rubans, est par exemple compris entre 3 et 6.

Les éléments d'interconnexion 403, 406, 406' sont posés dans l'alignement des bus 411 des cellules photovoltaïques 404, 404' et connectés électriquement au bus, de préférence par l'intermédiaire d'une colle conductrice. Ainsi, avant de poser une cellule photovoltaïque sur la couche 102 de matériau encapsulant adhésif, on procède à une étape de dépôt de la colle conductrice électriquement sur les bus 411 de ses deux faces. La colle conductrice électriquement est de préférence déposée par jet d'encre. Elle peut également être déposée par sérigraphie.

La colle conductrice électriquement est par exemple un matériau organique dans lequel sont dispersées des particules métalliques, comme de l'argent. Ce type de colle ressemble aux pâtes d'argent utilisées pour l'impression des doigts de collecte des cellules photovoltaïques mais sont formulées pour privilégier l'adhésion à la conduction électrique, notamment en utilisant des teneurs en composés organiques plus élevées et des taux de particules d'argent plus faibles. A titre d'exemple, il est possible d'utiliser des colles de type acrylate ou époxy, comme la colle commercialisée par la société Henkel sous la dénomination Hysol Eccobond CA3556HF à base d'acrylate.

Alternativement, la colle conductrice peut être composée de particules organiques enrobées d'un métal, ce qui permet de réduire davantage la quantité de métal utilisé et de diminuer ainsi le coût de la colle. A titre d'exemple, il est possible d'utiliser la colle commercialisée par la société Henkel sous la dénomination WCA 20746 composée de charges minérales revêtues d'argent.

La colle conductrice électriquement remplace avantageusement l'alliage fusible qui enrobe les rubans dans les techniques de soudure de l'art antérieur. Cela évite donc le risque de dissolution partielle des bus 411 au niveau des soudures par cet alliage fusible (phénomène appelé « solder leaching » en anglais), ainsi que l'agression des flux nécessaire pour réaliser les soudures. Ces flux sont des composés organiques permettant de désoxyder la surface des composants à assembler, tels que des acides faibles.

De plus, la colle conductrice électriquement est plus ductile qu'une soudure métallique ce qui réduit les contraintes mécaniques au niveau des interconnexions. Ces contraintes sont dues au fait que, au cours de son cycle de vie, le module photovoltaïque est soumis à d'importante variations de température et que les cellules photovoltaïques 404, 404' et les éléments d'interconnexions 403, 406, 406' sont formés de matériaux ayant des coefficients de dilatation très différents, par exemple en silicium et en cuivre respectivement. Grâce à la colle conductrice, le module photovoltaïque supporte plus facilement les contraintes de dilatation thermique et le risque d'endommagement des interconnexions est réduit.

La colle conductrice, juste après avoir été déposée, possède le caractère collant du matériau non séché, ce qui permet de maintenir en position, d'une part les cellules photovoltaïques 404, 404' sur les premier groupes d'éléments d'interconnexion 403, 406, et d'autre part les deuxièmes groupes d'éléments d'interconnexion 406, 406' sur les cellules photovoltaïques 404, 404'. Ainsi, lors de l'assemblage du module photovoltaïque, la colle conductrice peut remplacer les bandes d'adhésif.

Avec la configuration de bus discontinus 411 décrite en référence à la figure 5, la colle conductrice peut être déposée sous la forme de cordons continus reliant les plages métallisées 412. Cependant, la colle conductrice est de préférence déposée sous la forme de points de colle sur les plages métallisées 412, ce qui réduit ainsi la quantité de colle nécessaire, et donc le coût du module photovoltaïque.

Avantageusement, chaque point de colle est déposé de manière à couvrir une surface supérieure à celle de la plage métallisée 412. Ainsi, la fiabilité de l'interconnexion est augmentée. En effet, la colle conductrice électriquement adhère non seulement aux plages métallisées 412 mais aussi aux matériaux se trouvant autour. Il est donc possible de diminuer la taille des plages métallisées 412 par rapport aux techniques de soudure, ce qui réduit davantage le coût des cellules photovoltaïques 404, 404'. A l'inverse, dans les procédés de l'art antérieur utilisant la soudure, les contraintes mécaniques dans les interconnexions sont telles qu'il est impossible de réduire les dimensions des bus, et donc la quantité d'argent utilisée pour les imprimer. Par ailleurs, souder des rubans sur des plages métallisées de petites tailles est plus complexe et délicat, ce qui empêche d'avoir une cadence de production élevée, contrairement à l'utilisation de la colle conductrice électriquement.

Les plages métallisées 412 ont par exemple une surface de 250x250 µm² en face avant et de 500x250 µm² en face arrière, c'est-à-dire avec une largeur (selon la première direction X) deux fois plus grande en face arrière qu'en face avant. Ainsi l'alignement des rubans 403, 406, 406' avec les bus 411 est facilité sur la face arrière.

Dans ce deuxième mode de mise en œuvre, l'empilement est également soumis à une étape de lamination au cours de laquelle l'empilement est d'abord simultanément chauffé de manière à faire fondre ou ramollir les couches 102, 109 de matériau encapsulant et mis en dépression (par pompage) pour chasser l'air de l'empilement, puis pressé toujours à chaud pour assembler toutes les couches entre elles.

Avantageusement, la colle conductrice électriquement présente une température de début de durcissement (ou de réticulation) inférieure à la température de ramollissement des matériaux encapsulant. La température de début de durcissement de la colle conductrice électriquement est par exemple proche de 120°C. Ainsi, les connexions électriques entre les rubans et les bus 411 s'initient lorsque la température, au cours de l'étape de lamination, atteint cette température de début de durcissement, mais avant la fusion du matériau encapsulant. Le durcissement de la colle s'intensifie ensuite pendant le reste de l'étape de lamination, effectuée vers 150-160°C. Le fait de réaliser les connexions électriques pendant l'étape de lamination permet réduit le temps de production. De plus, le durcissement de la colle conductrice est réalisé à une température plus faible que celle à laquelle les soudures sont réalisées, ce qui réduit les contraintes engendrées au niveau des interconnexions.

La variante du premier mode de mise en œuvre du procédé de fabrication d'un module photovoltaïque selon l'invention, décrite en référence à la figure 3, peut également s'appliquer au deuxième mode de mise en œuvre qui vient d'être décrit.

Ainsi, grâce au procédé selon l'invention, les cellules photovoltaïques sont interconnectées directement dans le module photovoltaïque ce qui réduit le nombre d'étape nécessaire à sa fabrication. De plus, en réduisant le nombre d'étapes de fabrication, on augmente la cadence de production et on réduit le nombre des équipements dans la ligne de production. Par conséquent, le coût de production moyen d'un module photovoltaïque diminue.

Par ailleurs, les connections électriques entre les doigts de collecte des cellules photovoltaïques et les éléments d'interconnexions sont réalisées pendant l'étape de lamination, c'est-à-dire lorsque l'empilement du module photovoltaïque est terminé, les cellules photovoltaïques et les éléments d'interconnexions étant figés dans le module photovoltaïque. La fiabilité du module photovoltaïque, au niveau des interconnexions, est donc améliorée.

## Revendications

1. Procédé de fabrication d'un module photovoltaïque comportant des cellules photovoltaïques (104, 404), le procédé comportant les étapes suivantes :
- fournir une première plaque de protection (101) ;
- déposer sur la première plaque de protection (101) une couche (102) d'un matériau encapsulant, le matériau encapsulant étant un adhésif sensible à la pression ;
- poser alternativement sur la couche (102) de matériau encapsulant les cellules photovoltaïques (104, 404) et des éléments d'interconnexion (103, 106, 403, 406) aptes à relier électriquement les cellules photovoltaïques (104, 404), les éléments d'interconnexion étant répartis en des premiers groupes d'éléments d'interconnexion et des deuxièmes groupes d'éléments d'interconnexion, chaque cellule photovoltaïque étant posée en contact avec le matériau encapsulant sur un premier groupe d'éléments d'interconnexion (103, 403) et chaque cellule photovoltaïque étant recouverte par un deuxième groupe d'éléments d'interconnexion (106, 406).

2. Procédé selon la revendication 1 dans lequel les cellules photovoltaïques (104, 404) et les éléments d'interconnexion (103, 106, 403, 406) sont posés de manière à former au moins une chaîne de cellules photovoltaïques adjacentes connectées en série, selon la séquence suivante :
- (a) poser le premier groupe d'éléments d'interconnexion (103, 403) sur la couche (102) de matériau encapsulant ;
- (b) poser une cellule photovoltaïque (104, 404) sur le premier groupe d'éléments d'interconnexion (103, 403) ;
- (c) poser une première partie (106a) du deuxième groupe d'éléments d'interconnexion (106, 406) sur ladite cellule photovoltaïque et une deuxième partie (106b) du deuxième groupe d'éléments d'interconnexion (106, 406) sur une zone de la couche (102) de matériau encapsulant adjacente à ladite cellule photovoltaïque ;
les étapes (b) et (c) étant répétées pour chaque cellule photovoltaïque adjacente de ladite au moins une chaîne, la deuxième partie (106b) du deuxième groupe d'éléments d'interconnexion (106, 406) de ladite cellule photovoltaïque correspondant au premier groupe d'éléments d'interconnexion (103, 403) de la cellule photovoltaïque adjacente.

3. Procédé selon la revendication 2 dans lequel la deuxième partie (106b) du deuxième groupe d'éléments d'interconnexion (106, 406) est posée avant la première partie (106a) du deuxième groupe d'éléments d'interconnexion.

4. Procédé selon l'une quelconque des revendications 1 à 3 dans lequel les cellules photovoltaïques (104) présentent deux faces opposées, les cellules photovoltaïques (104) comportant sur chacune de leurs faces des doigts de collecte (105) s'étendant selon une première direction (X), les éléments d'interconnexion (103, 106) étant des fils d'interconnexion orientés selon une deuxième direction (Y) orthogonale à la première direction.

5. Procédé selon la revendication 4 comportant une étape de dépôt sur chaque cellule photovoltaïque (104) d'une bande d'adhésif (107) sensible à la pression maintenant en position le deuxième groupe d'éléments d'interconnexion (106) sur ladite cellule photovoltaïque.

6. Procédé selon l'une quelconque des revendications 4 à 5 comportant une étape de lamination du module photovoltaïque effectuée à une température permettant le ramollissement du matériau encapsulant, les fils d'interconnexion (103, 106) comportant un revêtement formé d'un alliage présentant un point de fusion inférieur à la température de ramollissement du matériau encapsulant.

7. Procédé selon l'une quelconque des revendications 4 à 6 dans lequel les fils d'interconnexion (103, 106) présentent un diamètre inférieur ou égal à 200µm.

8. Procédé selon l'une quelconque des revendications 1 à 3 dans lequel les cellules photovoltaïques (404) présentent deux faces opposées, les cellules photovoltaïques comportant sur chacune de leurs faces des doigts de collecte (405) s'étendant selon une première direction (X) et des bus (411) s'étendant selon une deuxième direction (Y) orthogonale à la première direction, les éléments d'interconnexion (403, 406) étant des rubans d'interconnexion alignés avec les bus des cellules photovoltaïques.

9. Procédé selon la revendication 8 comportant, avant la pose de chaque cellule photovoltaïque (404), une étape de dépôt d'une colle conductrice électriquement sur les bus (411) des deux faces de ladite cellule photovoltaïque, la colle conductrice électriquement maintenant en position ladite cellule photovoltaïque sur le premier groupe d'éléments d'interconnexion (403), et le deuxième groupe d'éléments d'interconnexion (406) sur ladite cellule photovoltaïque.

10. Procédé selon la revendication 9 dans lequel les bus (411) des cellules photovoltaïques (404) comprennent une succession de plages métallisées (412) espacées les unes des autres, la colle conductrice électriquement étant déposée sous forme de lignes reliant les plages métallisées ou sous forme de points de colle sur les plages métallisées.

11. Procédé selon la revendication 10 dans lequel chaque point de colle est déposé de manière à couvrir une surface supérieure à celle de la plage métallisée (412).

12. Procédé selon l'une quelconque des revendications 9 à 11 comportant une étape de lamination du module photovoltaïque effectuée à une température permettant le ramollissement du matériau encapsulant, la colle conductrice électriquement présentant une température de début de durcissement inférieure à la température de ramollissement du matériau encapsulant.

13. Procédé selon l'une quelconque des revendications 1 à 12 comportant les étapes suivantes :
- déposer une couche (109) d'un matériau encapsulant additionnel sur les cellules photovoltaïques (104, 404) et les éléments d'interconnexion (103, 106, 403, 406) ;
- placer une deuxième plaque de protection (110) sur la couche (109) de matériau encapsulant additionnel.

14. Procédé selon l'une quelconque des revendications 1 à 13 dans lequel les cellules photovoltaïques (104, 404) présentent deux faces opposées, les cellules photovoltaïques (104, 404) comportant sur chacune de leurs faces des doigts de collecte (105) s'étendant selon une première direction (X), le procédé comportant les étapes suivantes :
- découper les cellules photovoltaïques (104, 404) suivant une deuxième direction (Y) orthogonale à la première direction (X) pour former une pluralité de sous-cellules (1040) ;
- aligner des sous-cellules (1040) dans la première direction (X) de façon à constituer des groupes (104i, 104j) de sous-cellules (1040), chaque groupe (104i, 104j) de sous-cellules (1040) étant considéré et manipulé comme une seule cellule photovoltaïque (104, 404).

## Patentansprüche

1. Herstellungsverfahren eines photovoltaischen Moduls, umfassend photovoltaische Zellen (104, 404), wobei das Verfahren die folgenden Schritte umfasst:
- Liefern einer ersten Schutzplatte (101);
- Aufbringen einer Schicht (102) eines verkapselnden Materials auf der ersten Schutzplatte (101), wobei das verkapselnde Material ein drucksensibles Haftmaterial ist;
- Alternativ auf der verkapselnden Materialschicht (102) Aufbringen der photovoltaischen Zellen (104, 404) und Verschaltungselemente (103, 106, 403, 406), die geeignet sind, die photovoltaischen Zellen (104, 404) elektrisch miteinander zu verbinden, wobei die Verschaltungselemente in erste Gruppen von Verschaltungselementen und zweite Gruppen von Verschaltungselementen verteilt sind, wobei jede photovoltaische Zelle in Kontakt mit dem verkapselnden Material auf einer ersten Gruppe von Verschaltungselementen (103, 403) aufgebracht ist und jede photovoltaische Zelle von einer zweiten Gruppe von Verschaltungselementen (106, 406) abgedeckt ist.

2. Verfahren gemäß Anspruch 1, bei dem die photovoltaischen Zellen (104, 404) und die Verschaltungselemente (103, 106, 403, 406) derart angebracht sind, dass wenigstens eine Kette von anliegenden photovoltaischen Zellen, die in Serie angeschlossen sind, gemäß der folgenden Sequenz gebildet wird:
- (a) Anbringen der ersten Gruppe von Verschaltungselementen (103, 403) auf der verkapselnden Materialschicht;
- (b) Anbringen einer photovoltaischen Zelle (104, 404) auf der ersten Gruppe von Verschaltungselementen (103; 403);
- (c) Anbringen eines ersten Teils (106a) der zweiten Gruppe von Verschaltungselementen (106, 406) auf die genannte photovoltaische Zelle und einen zweiten Teil (106b) der zweiten Gruppe von Verschaltungselementen (106, 406) in einer Zone der verkapselnden Materialschicht, die an der genannten photovoltaischen Zelle anliegt;
wobei die Schritte (b) und (c) für jede anliegende photovoltaische Zelle der genannten wenigstens einen Zelle wiederholt werden, wobei der zweite Teil (106b) der zweiten Gruppe von Verschaltungselementen (106, 406) der genannten photovoltaischen Zelle der ersten Gruppe von Verschaltungselementen (104, 403) der anliegenden photovoltaischen Zelle entspricht.

3. Verfahren gemäß Anspruch 2, bei dem der zweite Teil (106b) der zweiten Gruppe von Verschaltungselementen (106, 406) vor dem ersten Teil (106a) der zweiten Gruppe von Verschaltungselementen angebracht wird.

4. Verfahren gemäß irgendeinem der Ansprüche 1 bis 3, bei dem die photovoltaischen Zellen (104) zwei entgegengesetzte Seiten aufweisen, wobei die photovoltaischen Zellen (104) auf jeder ihrer Seiten Erfassungsfinger (105) umfassen, die sich entlang einer ersten Richtung (X) erstrecken, wobei die Verschaltungselemente (103, 106) Verschaltungsdrähte sind, die gemäß einer zur ersten Richtung orthogonalen zweiten Richtung (Y) ausgerichtet sind.

5. Verfahren gemäß Anspruch 4, umfassend einen Aufbringungsschritt auf jeder photovoltaischen Zelle (104) eines druckempfindlichen Haftbandes (107), das die zweite Gruppe von Verschaltungselementen (106) auf der genannten photovoltaischen Zelle hält.

6. Verfahren gemäß irgendeinem der Ansprüche 4 bis 5, umfassend einen Walzschritt des photovoltaischen Moduls, der bei einer Temperatur ausgeführt wird, die das Aufweichen des verkapselnden Materials erlaubt, wobei die Verschaltungsdrähte (103, 106) eine Abdeckung umfassen, die aus einer Legierung gebildet wird, die einen Schmelzpunkt unterhalb der Aufweichtemperatur des verkapselnden Materials aufweist.

7. Verfahren gemäß irgendeinem der Ansprüche 4 bis 6, bei dem die Verschaltungsdrähte (103, 106) einen Durchmesser von weniger als oder gleich 200 µm aufweisen.

8. Verfahren gemäß irgendeinem der Ansprüche 1 bis 3, bei dem die photovoltaischen Zellen (404) zwei entgegengesetzte Seiten aufweisen, wobei die photovoltaischen Zellen auf jeder ihrer Seiten Erfassungsfinger (405), die sich gemäß einer ersten Richtung (X) erstrecken, und Busse (411), die sich gemäß einer zur ersten Richtung orthogonalen zweiten Richtung (Y) erstrecken, umfassen, wobei die Verschaltungselemente (403, 406) mit den Bussen der photovoltaischen Zellen ausgerichtete Verschaltungsbänder sind.

9. Verfahren gemäß Anspruch 8, umfassend vor dem Anbringen jeder photovoltaischen Zelle (404) einen Aufbringungsschritt eines elektrisch leitenden Klebstoffs auf den Bussen (411) der zwei Seiten der genannten photovoltaischen Zelle, wobei der elektrisch leitende Klebstoff die genannte photovoltaische Zelle auf der ersten Gruppe von Verschaltungselementen (403) und die zweite Gruppe von Verschaltungselementen (406) auf der genannten photovoltaischen Zelle in Position hält.

10. Verfahren gemäß Anspruch 9, in dem der genannte Bus (411) der photovoltaischen Zellen (404) eine Folge von metallischen Platten (412) umfasst, die voneinander beabstandet sind, wobei der elektrisch leitende Klebstoff in Form von Linien, die die metallisierten Bereiche miteinander verbinden, oder in Form von Klebepunkten auf den metallisierten Bereichen aufgebracht wird.

11. Verfahren gemäß Anspruch 10, bei dem jeder Klebepunkt derart aufgebracht wird, dass eine Oberfläche oberhalb der des metallisierten Bereichs (412) abgedeckt wird.

12. Verfahren gemäß irgendeinem der Ansprüche 9 bis 11, umfassend einen Walzschritt des photovoltaischen Moduls, der bei einer Temperatur ausgeführt wird, die das Aufweichen des verkapselnden Materials zulässt, wobei der elektrisch leitende Klebstoff eine Anfangstemperatur der Härtung von weniger als der Aufweichtemperatur des verkapselnden Materials aufweist.

13. Verfahren gemäß irgendeinem der Ansprüche 1 bis 12, umfassend die folgenden Schritte:
- Aufbringen einer Schicht (109) eines zusätzlichen verkapselnden Materials auf den photovoltaischen Zellen (104, 404) und den Verschaltungselementen (103, 106, 403, 406);
- Platzieren einer zweiten Schutzplatte (110) auf der Schicht (109) aus zusätzlichem verkapselndem Material.

14. Verfahren gemäß irgendeinem der Ansprüche 1 bis 3, bei dem die photovoltaischen Zellen (104, 404) zwei entgegengesetzte Seiten aufweisen, wobei die photovoltaischen Zellen (104, 404) auf jeder ihrer Seiten Erfassungsfinger (105) aufweisen, die sich gemäß einer ersten Richtung (X) erstrecken, wobei das Verfahren die folgenden Schritte umfasst:
- Ausschneiden der photovoltaischen Zellen (104, 404) gemäß einer zur ersten Richtung (X) orthogonalen zweiten Richtung (Y) zum Bilden einer Vielzahl von Unterzellen (1040);
- Ausrichten der Unterzellen (1040) in der ersten Richtung (X) derart, dass Gruppen (104i, 104j) aus Unterzellen (1040) gebildet werden, wobei jede Gruppe (104i, 104j) von Unterzellen (1040) als eine einzelne photovoltaische Zelle (104, 404) betrachtet und gehandhabt wird.

## Claims

1. Method for manufacturing a photovoltaic module comprising photovoltaic cells (104, 404), the method comprising the following steps:
- providing a first protective plate (101);
- depositing on the first protective plate (101) a layer (102) of an encapsulating material, the encapsulating material being a pressure sensitive adhesive;
- alternately laying on the layer (102) of encapsulating material photovoltaic cells (104, 404) and interconnection elements (103, 106, 403, 406) capable of electrically connecting the photovoltaic cells (104, 404), the interconnection elements being divided into first groups of interconnection elements and second groups of interconnection elements, each photovoltaic cell being laid in contact with the encapsulating material on a first group of interconnection elements (103, 403) and each photovoltaic cell being covered by a second group of interconnection elements (106, 406).

2. Method according to claim 1 wherein the photovoltaic cells (104, 404) and the interconnection elements (103, 106, 403, 406) are laid in such a way as to form at least one string of adjacent photovoltaic cells connected in series, according to the following sequence:
- (a) laying the first group of interconnection elements (103, 403) on the layer (102) of encapsulating material;
- (b) laying a photovoltaic cell (104, 404) on the first group of interconnection elements (103, 403);
- (c) laying a first part (106a) of the second group of interconnection elements (106, 406) on said photovoltaic cell and a second part (106b) of the second group of interconnection elements (106, 406) on a zone of the layer (102) of encapsulating material adjacent to said photovoltaic cell;
steps (b) and (c) being repeated for each adjacent photovoltaic cell of said at least one string, the second part (106b) of the second group of interconnection elements (106, 406) of said photovoltaic cell corresponding to the first group of interconnection elements (103, 403) of the adjacent photovoltaic cell.

3. Method according to claim 2 wherein the second part (106b) of the second group of interconnection elements (106, 406) is laid before the first part (106a) of the second group of interconnection elements.

4. Method according to any of claims 1 to 3 wherein the photovoltaic cells (104) have two opposite faces, the photovoltaic cells (104) comprising on each of their faces collecting fingers (105) extending along a first direction (X), the interconnection elements (103, 106) being interconnection wires oriented along a second direction (Y) orthogonal to the first direction.

5. Method according to claim 4 comprising a step of deposition on each photovoltaic cell (104) of a strip of pressure sensitive adhesive (107) maintaining the second group of interconnection elements (106) in position on said photovoltaic cell.

6. Method according to any of claims 4 to 5 comprising a step of lamination of the photovoltaic module carried out at a temperature enabling the softening of the encapsulating material, the interconnection wires (103, 106) comprising a coating formed of an alloy having a melting point below the softening temperature of the encapsulating material.

7. Method according to any of claims 4 to 6 wherein the interconnection wires (103, 106) have a diameter less than or equal to 200 µm.

8. Method according to any of claims 1 to 3 wherein the photovoltaic cells (404) have two opposite faces, the photovoltaic cells comprising on each of their faces collecting fingers (405) extending along a first direction (X) and buses (411) extending along a second direction (Y) orthogonal to the first direction, the interconnection elements (403, 406) being interconnection ribbons aligned with the buses of the photovoltaic cells.

9. Method according to claim 8 comprising, before the laying of each photovoltaic cell (404), a step of deposition of an electrically conductive adhesive on the buses (411) of the two faces of said photovoltaic cell, the electrically conductive adhesive maintaining said photovoltaic cell in position on the first group of interconnection elements (403), and the second group of interconnection elements (406) on said photovoltaic cell.

10. Method according to claim 9 wherein the buses (411) of the photovoltaic cells (404) comprise a succession of metallised areas (412) spaced apart from each other, the electrically conductive adhesive being deposited in the form of lines connecting the metallised areas or in the form of spots of adhesive on the metallised areas.

11. Method according to claim 10 wherein each spot of adhesive is deposited in such a way as to cover a surface greater than that of the metallised area (412).

12. Method according to any of claims 9 to 11 comprising a step of lamination of the photovoltaic module carried out at a temperature enabling the softening of the encapsulating material, the electrically conductive adhesive having a start of hardening temperature below the softening temperature of the encapsulating material.

13. Method according to any of claims 1 to 12 comprising the following steps:
- depositing a layer (109) of an additional encapsulating material on the photovoltaic cells (104, 404) and the interconnection elements (103, 106, 403, 406);
- placing a second protective plate (110) on the additional layer (109) of encapsulating material.

14. Method according to any of claims 1 to 13 wherein the photovoltaic cells (104, 404) have two opposite faces, the photovoltaic cells (104, 404) comprising on each of their faces collecting fingers (105) extending along a first direction (X), the method comprising the following steps:
- cutting the photovoltaic cells (104, 404) along a second direction (Y) orthogonal to the first direction (X) to form a plurality of sub-cells (1040);
- aligning the sub-cells (1040) in the first direction (X) so as to constitute groups (104i, 104j) of sub-cells (1040), each group (104i, 104j) of sub-cells (1040) being considered and handled as a single photovoltaic cell (104, 404).
